Europäisches Patentamt

European Patent Office

Office européen des brevets

(11) Publication number: **0 035 146**
**B1**

# EUROPEAN PATENT SPECIFICATION

(45) Date of publication of patent specification: **12.10.88**

(21) Application number: **81100992.7**

(22) Date of filing: **12.02.81**

(51) Int. Cl.⁴: $H\ 01\ L\ 31/08$, $H\ 01\ L\ 31/18$, $H\ 01\ L\ 31/02$, $H\ 01\ L\ 27/14$

(54) Semiconductor photoelectric device.

(30) Priority: **15.02.80 JP 18114/80**
**12.03.80 JP 31801/80**
**12.03.80 JP 31812/80**
**07.04.80 JP 45912/80**
**07.04.80 JP 45916/80**
**04.07.80 JP 92020/80**

(43) Date of publication of application:
**09.09.81 Bulletin 81/36**

(45) Publication of the grant of the patent:
**12.10.88 Bulletin 88/41**

(84) Designated Contracting States:
**DE FR GB**

(56) References cited:
**DE-A-2 618 733**
**DE-A-2 933 411**
**FR-A-2 412 874**
**GB-A-2 064 867**
**US-A-4 064 521**

(73) Proprietor: **Matsushita Electric Industrial Co., Ltd.**
**1006, Oaza Kadoma**
**Kadoma-shi Osaka-fu, 571 (JP)**

(72) Inventor: **Ishihara, Shinichiro**
**107, Yagumokitamachi 2-chome**
**Moriguchi City 570 (JP)**
Inventor: **Mori, Koshiro**
**7-2-421, Shinmori 1-chome**
**Asahi-ku Osaka City 535 (JP)**
Inventor: **Tanaka, Tsuneo**
**6, Ohide-cho 6-chome**
**Nishinomiya City 662 (JP)**
Inventor: **Nagata, Seiichi**
**10-4, Takeshirodai 2-cho**
**Sakai City, 590-01 (JP)**

(74) Representative: **Dr. Elisabeth Jung Dr. Jürgen Schirdewahn Dipl.-Ing. Claus Gernhardt**
**P.O. Box 40 14 68 Clemensstrasse 30**
**D-8000 München 40 (DE)**

Courier Press, Leamington Spa, England.

## Description

### Background of the invention

The present invention relates to a semiconductor photoelectric device. More particularly, the present invention concerns a semiconductor photoelectric device, where a relatively high voltage is to be impressed across its photoconductor layer, for example, a semiconductor photoelectric device for obtaining a two-dimensional photographic image, such as a xerographic photosensitive plate as well as a target plate of a pick-up tube, or other semiconductor photoelectric devices such as, a photovoltaic device.

Photoconductor layers of a xerographic characteristic, such as those of organic resin films containing dispersed fine particles of CdS or ZnO, or amorphous Se containing As or Te as an additive, or organic semiconductors such as polyvinylcarbazole or trinitrofluorene are known. However, the amorphous Se offers difficulties in respect of controlling its contents and furthermore shows, unstability of characteristic due to crystallization under a high temperature, and is a poison as such. On the other hand, an organic resin film containing dispersed CdS or ZnO is dependent on moisture and hence there is a difficulty in obtaining a good picture image in moist atmosphere. The organic semiconductor photosensitive plate offers problems in respect of toxicity and poor antiabrasion characteristics.

As a new material to overcome such conventional problems, hydrogenated or fluorinated amorphous silicon has recently attracted attention, see for example, the statements about its usefulness in the Japanese published unexamined patent gazette Sho 54-78135 or Sho 54-86341. In the conventional amorphous silicon, the specific resistivity of the non-doped material of the n-type at the room temperature, is $10^8$ to $10^{10}$ $\Omega \cdot$ cm, and the specific resistivity increases with a volume ratio of $B_2H_6$ to $SiH_4$ in forming the Si layer increasing to $10^{-4}$ mol to reach a value of about $10^{12}$ $\Omega \cdot$ cm, but the specific resistivity rapidly decreases with the ratio increasing further. In order to use the photoelectric material in a xerographic photosensitive plate, or in a picture pick-up tube, it is requested that the photoelectric material should have a dark specific resistivity at room temperature of at least $10^{13}$ $\Omega \cdot$ cm. Hitherto, there has been no prior art disclosing an art to manufacture a photoelectric material of such characteristics.

On the other hand, it is known that an undoped amorphous silicon made by plasma decomposition of $SiH_4$ or $SiF_4$ has an energy gap (Eg) of about 1.6 to 1.8 eV, and when an amount of addition of an acceptor of a group III element such as B, increases, the energy gap decreases, in such a manner that the Eg is lowered to 1.4 eV when a volume ratio of $B_2H_6$ added to $SiH_4$ in manufacturing Si layer is 1%. In case such a p-type amorphous Si layer is used in a semiconductor photoelectric device of a p-i-n structure, for example, a photovolataic device, the light absorption at the surface of the p-type layer becomes large due to the fact that its energy gap is lower than that of the i-type layer, and hence a satisfactory photoelectric effect is not obtainable. Furthermore, when such conventional p-i-n structure device is made by using the amorphous p-type Si, it has such shortcomings as low reverse breakdown voltage and large dark current, hence has low utility in pick-up devices or the like.

### Summary of the invention

The present invention as characterized by the features of claim 1 provides a semiconductor photoelectric device capable of overcoming the abovementioned problems.

That is, the present invention can provide a semiconductor photoelectric device having an amorphous photoelectric layer with a high dark specific resistivity and also a high photoconductivity. Further, the present invention can provide an amorphous photoelectric layer of a large band gap. Further, the present invention can provide a semiconductor photoelectric device having superior forward and reverse current-voltage characteristics and superior photoelectric conversion characteristic.

### Brief explanation of the drawing

Fig. 1 is a schematic view showing one example of apparatuses for manufacturing solid state devices embodying the present invention.

Fig. 2 is a graph showing a relationship between optical band gap Eg and oxygen gas volume ratios to $SiH_4$ gas in an a · Si layer.

Fig. 3 is a graph showing a relationship between characteristic X-ray intensity ratios and oxygen gas volume ratios to $SiH_4$ gas in an a · Si layer.

Fig. 4 is a graph showing a relationship between optical band gap Eg and $B_2H_6$ gas volume ratios to $SiH_4$ gas in an a · Si layer.

Fig. 5 is a graph showing a relationship between activation energy Ea and $B_2H_6$ gas volume ratios to $SiH_4$ gas in an a · Si layer, using as a parameter $O_2$ gas volume ratios to $SiH_4$ gas.

Fig. 6 is a schematic view showing a photoconductive device together with measurement circuit elements.

Fig. 7 is a graph showing current vs. bias voltage characteristic curves obtained for photoconductive devices with the device structure of Fig. 6.

Fig. 8 is a graph showing a relationship between spectroscopic sensitivity and wave length, for photoconductive devices with an O-doped a · Si layer and a non-doped a · Si layer.

Fig. 9 is a graph showing conductivity dependence on illumination (1x) of light impinging upon a · Si layer with O atoms doped and undoped.

Fig. 10 is a cross-sectional elevation view of a specimen structure used for corona electrification and discharging tests.

Fig. 11 is a cross-sectional elevation view of a structure of a device embodying the present invention.

Fig. 12 is a graph showing potential decaying characteristic curves for the photoconductive devices embodying the present invention.

Fig. 13 is a cross-sectional elevation view of a structure of a device embodying the present invention.

Fig. 14 is a graph showing a curve of spectroscopic sensitivity characteristics for a photoconductive device used as a target of a solid state image sensing device.

Fig. 15 is a cross-sectional elevation view showing one device element of a solid state image sensing device embodying the present invention.

Fig. 16 is a cross-sectional elevation view of a multi-layered p-i-n structure of a photoconductive device embodying the present invention.

Fig. 17 is a graph showing a relationship between forward/reverse bias voltages vs. current density, for the photoconductive device of Fig. 16.

Fig. 18 is a graph showing quality factor dependence on $O_2$ gas volume ratios to $SiH_4$ gas volume, for a diode with the structure of Fig. 16.

Fig. 19 is a graph showing reverse current density dependence on $O_2$ gas volume ratios to $SiH_4$ gas volume, for a diode with the structure of Fig. 16.

Fig. 20 is a graph showing a relationship between reverse bias voltage and current, for devices with O atoms doped and undoped with the device structure of Fig. 16.

Fig. 21 is a graph showing spectroscopic sensitivity dependence on wave length, for the devices with O atoms doped and undoped with the device structure of Fig. 16.

Figs. 22(A) and 22(B) are cross-sectional elevation views showing p-i-n device structures of photovoltaic cells embodying the present invention.

Fig. 23 is a graph showing photovoltaic cell characteristics for photovoltaic cells in accordance with a prior art and the present invention.

## Description of the preferred embodiments

The present invention is based on a discovery that a high dark specific resistivity at the room temperature is obtainable retaining superior photoconductive characteristic by adding oxygen besides known impurity such as B, P or As for charge carrier concentration controlling, thereby enabling to provide an amorphous silicon layer having a larger band gap than that of the conventional amorphous silicon layer, and having a very low specific resistivity retaining a similar activation energy as that of the conventional p-type amorphous silicon layer.

An amorphous silicon layer containing oxygen in an atomic proportion 2 to 45% is known from DE—A—2318733. However this layer is not used as a photoelectric conversion layer.

The semiconductor photoelectric device in accordance with the present invention comprises an amorphous silicon layer which contains a considerable amount of oxygen therein, the ratio of the number of oxygen atoms to the silicon atoms being comprised between 0.03 and 0.1.

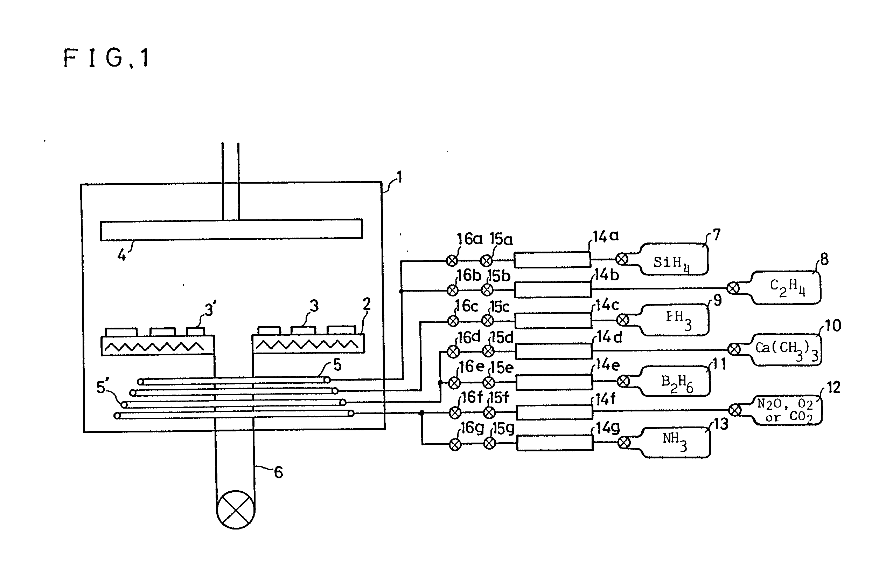

Fig. 1 schematically shows a reactor to manufacture a semiconductor device embodying the present invention, wherein in a reactor 1, substrates 3, 3' of, for example, glass, are disposed on a holder 2 and a counter electrode 4 is held over the holder 2. A high frequency voltage of, for example, 13.5 MHz, or a DC voltage is impressed across the holder 2 and the counter electrode 4. Gas distribution pipes 5, 5' are disposed in the reactor 1, for example under the holder 2, so as to uniformly distribute source gases therethrough, and the gases are put away the reactor 1 through an outlet pipe 6. Gas containers 7, 8, 9, 10, 11, 12 and 13 respectively contain the following source gases:

| 7 | $SiH_4$ |
| 8 | $C_2H_4$, |
| 9 | $PH_3$, |
| 10 | $Ga(CH_3)_3$, |
| 11 | $B_2H_6$, |
| 12 | $N_2O$, $O_2$, or $CO_2$, and |
| 13 | $NH_3$ |

And these containers are connected to the gas distribution tubes 5 through flow meters 14a, 14b, 14c, 14d, 14e, 14f and 14g, flow rate adjusting valves 15a, 15b, 15c, 15d, 15e, 15f and 15g and control valves 16a, 16b, 16c, 16d, 16e, 16f and 16g.

The reactor is operated to carry out glow discharge deposition under the prssure of 1,33 to 1332 Pa ($10^{-2}$ Torr to $10^2$ Torr) of the source gases so as to form desired amorphous films.

Experiments are made by switchingly using both $SiH_4$ diluted with He and $SiH_4$ diluted with Ar. For the container 12, that filled with $O_2$, that filled with $N_2O$ and that filled with $CO_2$ are switchingly used. For the gases $PH_3$, $B_2H_6$, those dilued with He are used.

By using the reaction system shown in Fig. 1, and by means of conventional reaction, an undoped amorphous silicon layer is deposited on the substrate 3, 3'. The dark specific resistivity of the silicon layer is not dependent on the diluting gas and is in a range between $10^8$ to $10^{10}$ $\Omega \cdot cm$; but the photoconductivity of the silicon layer made from the He-diluted source gas is as large as about twice that of the silicon layer made from the Ar-diluted source gas. The deposited silicon layer is then heated and the gas decomposed therefrom is mass-analized, and it is found that a layer made from the Ar-diluted $SiH_4$ discharges Ar, but a layer made from the He-diluted $SiH_4$ discharges no He of the level above the background noise of the analyzing system. Accordingly, the experiments were made by using He-diluted $SiH_4$, where the volume ratio is $SiH_4$:He=1:4.

Then, concentration of $PH_3$ and $B_2H_6$ with respect to $SiH_4$ is decreased to 10 ppm to 3%, and relation between the doping concentration and dark specific resitivity at the room temperature is examined, and it is observed that the relation substantially agrees to the report by Spear et al. on the Solid State Communication Vol. 17, p 1193 (1975). That is, the confirmed fact is that the maximum dark specific resistivity at the room temperature ($\rho$D) is of the order of $10^{12}$ $\Omega \cdot$ cm and the condition to make such value is the very much delimited condition that the ratio of $V_{B_2H_b}/V_{SiH_4}$ is:

$$\delta(V_{B_2H_6}/V_{SiH_4})=(1\pm0.5)\times10^2 \text{ ppm}$$

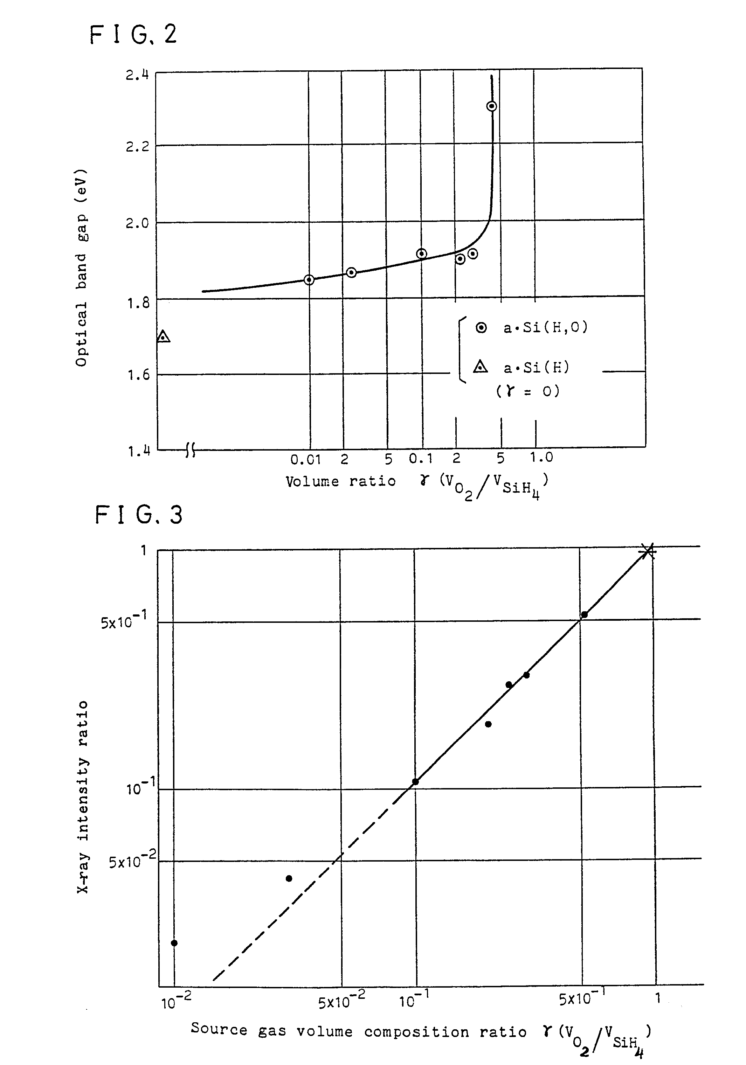

Based on the abovementioned confirmation of the conventional art of deposition of the amorphous silicon layer, the following experiments are made. An amorphous silicon layer with oxygen addition (hereinafter referred to as a $\cdot$ Si (H, O) can be formed by carrying out a plasma decomposition when both He-diluted $SiH_4$ and $O_2$ are being supplied to the reactor 1 of Fig. 1. Fig. 2 is a graph showing a relation between $V_{O_2}/V_{SiH_4}$ volume ratio $\gamma$ in the reactor and an optical band gap Eg of the resultant a $\cdot$ Si (H, O) layer. Fig. 2 shows that for the value of $\gamma=0$, the band gap Eg≃1.7 eV, and that for the value $\gamma$ of $0.01\leq\gamma\leq0.3$, the Eg is in the range of 1.85 to 1.92 eV, and further Eg rapidly increases for $\gamma\geq0.5$. That is to say, a material of $\gamma\geq0.5$ hardly shows photoconductivity, and therefore, $\gamma$ is preferably 0.5 or smaller in order to be used for photoelectric devices. When $\gamma\leq0.3$, current under illumination becomes very large in comparison with dark current, that is a superior photoconductivity is observed.

Fig. 3 is a graph showing a characteristic curve of a relation between the volume ratio of the source gas and X-ray signal intensity of a $\cdot$ Si (H, O) measured by using a 5 KeV primary electron beam with an energy distribution type X-ray analyzer of Model 711 of EDAX corporation. In the graph, dots show characteristic X-ray intensity ratios of oxygen and silicon as functions of source gas ratio $\gamma$. As is obvious from Fig. 3, the X-ray intensity ratios of O and Si is substantially proportional to the source gas ratio $\gamma$, and can be approximated by a straight line of the graph. On the other hand, a point indicated by a mark X shows a characteristic X-ray intensity ratio of a thermal oxidation $SiO_2$ film of a single crystalline silicon layer. As shown in Fig. 3, the point X is placed at an exterpolated point of the straight line, since the characteristic X-ray intensity ratio and the gas ratio $\gamma$ is proportional and the ratio must be proportional to the gas mixing ratio.

As is obviously understood from the descriptions above, the a $\cdot$ Si (H, O) wherein the mixing ratio of oxygen and silicon is under unity (this corresponds to $\gamma<0.5$) has a satisfactory photoresistivity and at the same time has a large band gap. Especially, the a $\cdot$ Si (H, O) of $0.01\leq\gamma\leq0.3$, that is the Si layer having the ratio of oxygen to silicon of between 0.02 to 0.6, has a preferable photoresistivity.

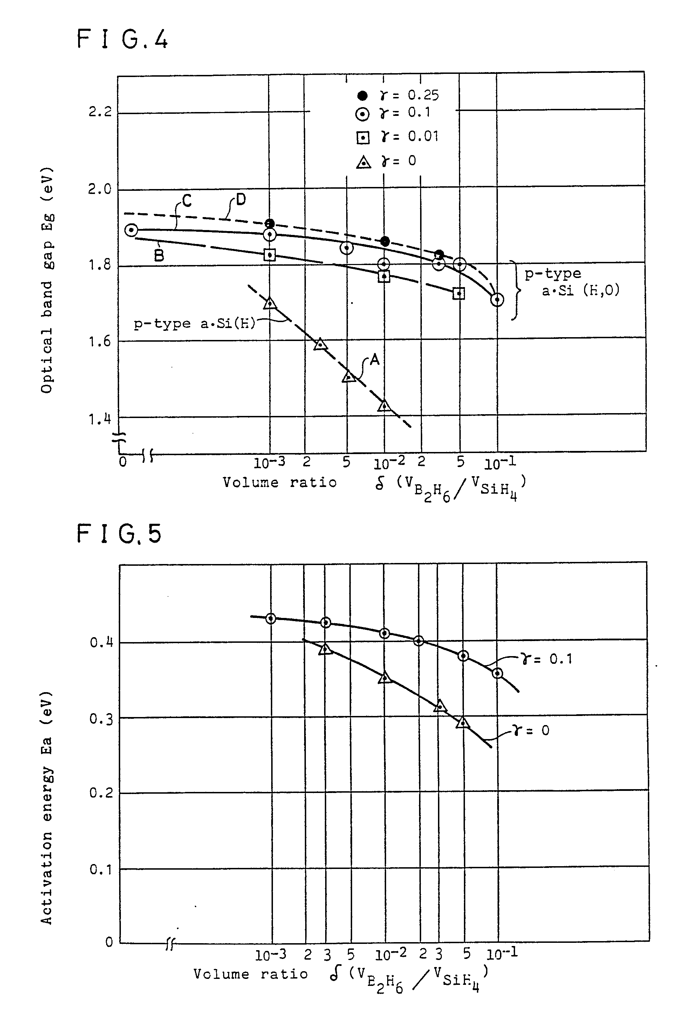

In order to add doping impurity for charge carrier density controlling, a source gas for such impurity, for example, $B_2H_6$, is mixed to the abovementioned source gases of $SiH_4$ and $O_2$, so that the impurity source gas is also plasma-decomposed. Fig. 4 is a graph showing a relation between optical band gap Eg and volume ratio

$$\delta(=V_{B_2H_6}/V_{SiH_4})$$

of the source gases $B_2H_6$ and $SiH_4$ of a p-type a $\cdot$ Si (H, O) which includes B as an acceptor. In the graph, the curves A, B, C and D are for the samples made from the following source gases:

|  |  |
|---|---|
| curve A | $\gamma=0,$ |
| curve B | $\gamma=0.01$ |
| curve C | $\gamma=0.1$, and |
| curve D | $\gamma=0.25.$ |

As is obvious from Fig. 4, when $\delta=0$, the Eg value increases as $\gamma$ increases. On the other hand, even when a considerable amount of acceptor is added, reduction of Eg remarkably decreases by addition of oxygen. Further, by appropriately selecting the value of $\gamma$ and $\delta$, it is even possible to make the Eg value of a p-type a $\cdot$ Si (H, O) layer with a considerable concentration of B be larger than that of an undoped a $\cdot$ Si(H) (wherein $\gamma=\delta=0$). Therefore, by utilizing the a $\cdot$ Si (H, O) of the present invention for the light incident layer of a photoelectric device, it is possible to attain a low light absorption in the p-type layer, thereby increasing intensity of light to reach the adjacent i-type layer and increasing the photoelectric efficiency of the device.

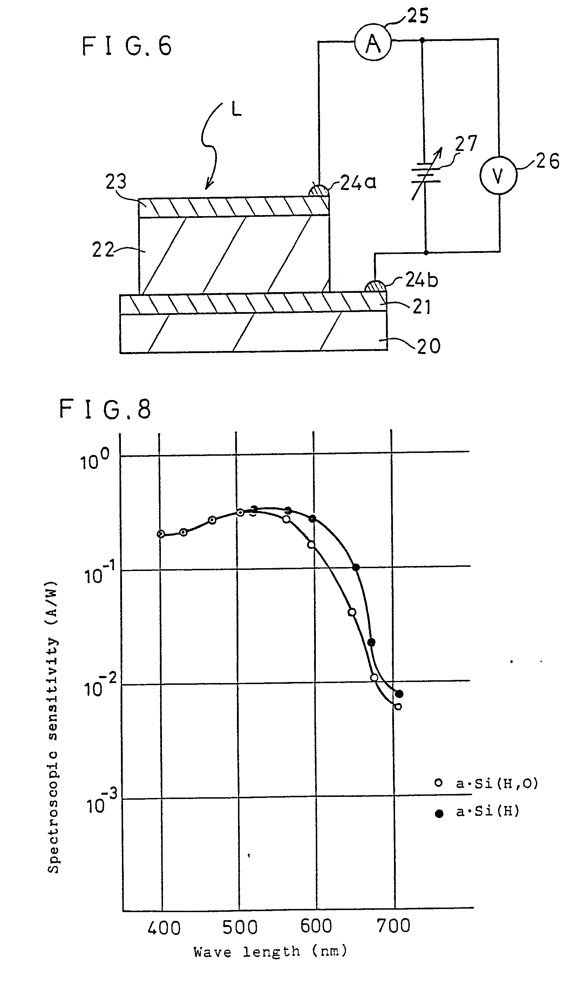

Fig. 5 is a graph showing relations between activation energy Ea(eV) and the mixing ratio $\delta$, which corresponds to the doping concentration of the acceptor. As is shown by the curves, the value of Ea for the $\gamma=0.1$ is larger than that of the $\gamma=0$; that means, by addition of oxygen the impurity level of B becomes deeper in the valence band. However, by making a value Eg—Ea from the curves of Fig. 4 and Fig. 5 and considering the values for different $\gamma$ values, it is observed that this value Eg—Ea increases as the oxygen component increases. That is, the energy difference between the conduction band and the acceptor impurity level increases as the amount of added oxygen increases. Therefore, when a junction between the p-type layer and i-type layer is formed, internal electric field in the i-type layer becomes large by using a p-type layer with oxygen addition in accordance with the present invention.

Embodiment I:

Fig. 6 is a schematic view showing a photoconductive device with measurement circuit elements. The photoconductive device comprises single crystalline Si wafer 20, an evaporated Mo film 21 of about 140 nm (1,400Å) in thickness, and a $\cdot$ Si (H, O) layer 22 deposited by a glow discharge method on the Mo film 21 by about 1 μm, and an evaporated Au thin film 23 with about 50% transmittance for visible light. The photoconductive device is provided with an electrode bump 24a on the Au thin film 23, and another electrode bump 24b on the Mo film 21. In Fig. 6 are further shown an ammeter 25, a voltage source 27 and a volt meter 26. Current-voltage characteristics were obtained for the photoconductive device with the a · Si (H, O) layer prepared by the gas mixing ratio γ of 0.15, and for another photoconductive device provided with an a · Si (H) layer prepared by the gas mixing ratio γ=0, instead of the a · Si (H, O) layer in the device structure shown in Fig. 6.

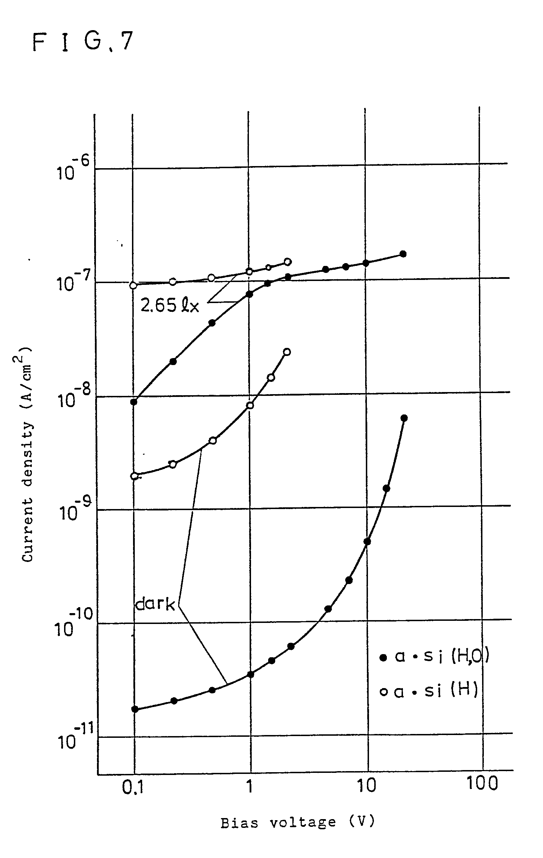

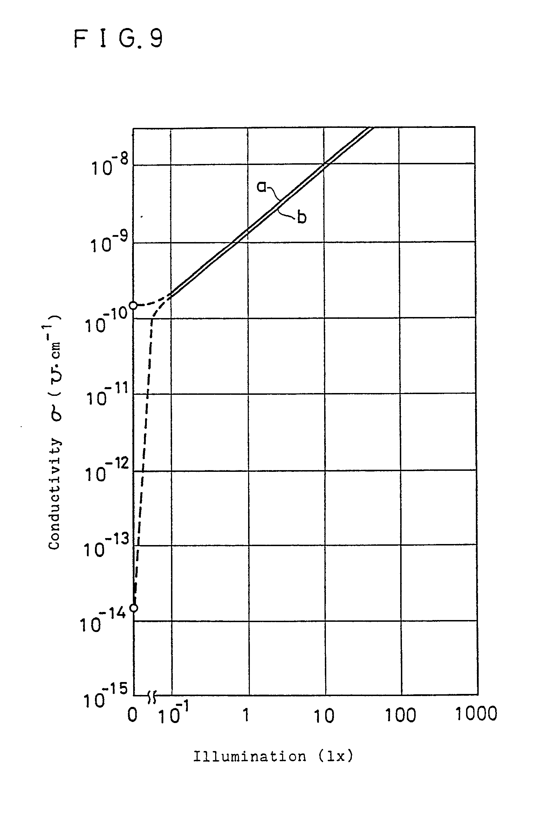

Current-voltage (I—V) curves as shown in Fig. 7 were obtained for these photoconductive devices, respectively for both cases of light irradiation and non-irradiation of light. Spectroscopic sensitivity data also measured for those photoconductive devices are shown by curves in Fig. 8. Curves indicated by a small circle and a dot both in Figs. 7 and 8 correspond to the data for the photoconductive devices with the a · Si (H) and a · Si (H, O) layers, respectively. The spectroscopic sensitivity data were measured by light irradiation of 2.65 lx illumination. It is clearly shown in Fig. 7 that the photoconductive device with the a · Si (H, O) layer is much superior in the photoconductive device characteristics. That is, the dark current drastically decreases and further breakdown voltage remarkably increases, while its spectroscopic sensitivity is almost as good as that of the conventional photoconductive device with the a · Si (H) layer, as shown in Fig. 8.

Embodiment II:
A quartz glass plate, another quartz glass plate coated with an evaporated Al film, and a single crystal Si plate of high impurity are employed as substrates, and are placed inside the reaction apparatus shown in Fig. 1. Doped amorphous Si layers are formed by a conventional glow discharge method under the following conditions.

| | |
|---|---|
| Gas mixing ratio $\delta(V_{B_2H_6}/V_{SiH_4})$ | 100 ppm, |
| Gas mixing ratio $(V_{N_2O}/V_{SiH_4})$ | about 5%, |
| Substrate temperature and | 250°C, |
| Film thickness of the a · Si (H, O) | about 10 μm. |

Two parallel electrode regions are formed by chromium evaporation on the amorphous silicon layers, and resistivity measurement for the amorphous Si layer on the quartz glass plate at room temperature turned out to be $10^{13}$ to $10^{14}$ Ω · cm. In infrared absorption measurement for the amorphous Si layer on the single crystal Si plate of high purity, a strong absorption spectrum peculiar to SiO was observed in addition to the Si—H absorption spectrum.

Fig. 9 is a graph showing conductivity dependence on illumination (lx) of light impinging upon the amorphous Si layers. The curves indicated by "a" and "b" correspond to the specimens provided with the non-doped amorphous Si layer prepared from $SiH_4$ and with the amorphous Si layer doped with B and O atoms, by use of $B_2H_6$ and $N_2O$ added to $SiH_4$, respectively. Two open circles on the ordinate indicate conductivity values ($\sigma_D$) in the dark. As is clearly shown in Fig. 9, $\sigma_D$ drops to the order of $10^{-14}$ by doping B and O atoms in the amorphous Si layer. The specimen with such impurity doping possesses photoconductivity as superior as the specimen with the non-doped amorphous Si layer.

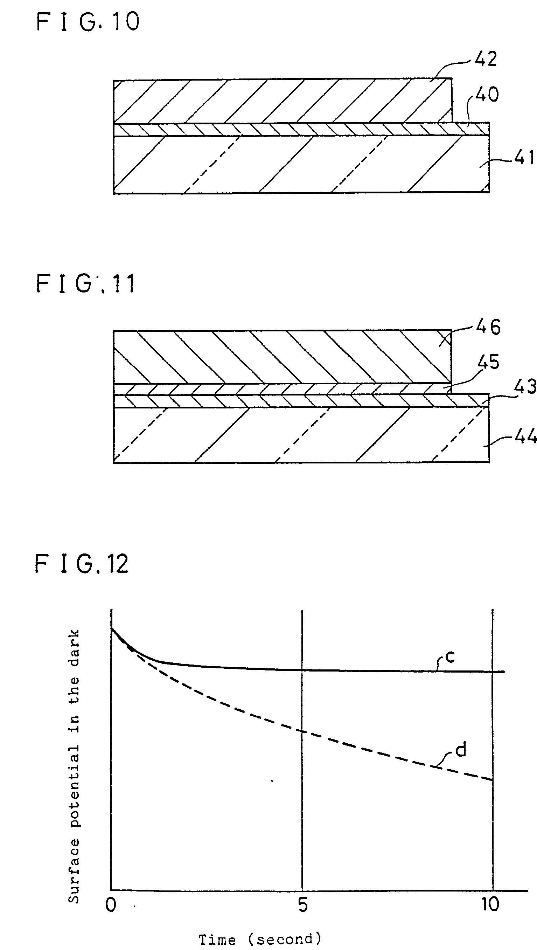

On the other hand, a specimen comprising a quartz glass substrate 41 coated with an evaporated Al film 40, and an amorphous Si layer 42 doped with B and O atoms, as shown in Fig. 10, was placed on a testing apparatus for corona electrification and light irradiation discharging tests. The testing apparatus was used to trigger corona discharge with 7,000 V application for the purpose of inducing negative charges on the surface of the a · Si layer 42. Initial surface potential by such electrification in the dark was measured to be −500 V. Following to exposure of light amount of 1 lx · sec (illumination times exposure time), the surface potential rapidly decayed to result in a residual potential of −30 V.

Embodiment III:
A quartz glass substrate 44 coated with an evaporated Al film 43 as shown in Fig. 11 was placed inside the plasma reaction apparatus, and then an n⁺-type a · Si layer 45 was formed by deposition of a glow discharge method under the following reaction conditions:

| | |
|---|---|
| Gas mixing ratio of $V_{PH_3}/V_{SiH_4}$ | 3%, |
| Substrate temperature and | 250°C, |
| Film thickness | about 50 nm (500 Å) |

Following the n⁺-type layer deposition, an a · Si (H, O) film 46 doped with B and O atoms was formed thereon by about 10 μm under conditions similar to the case of Embodiment II, thus producing a photoconductive device. The photoconductive device was similarly tested for corona electrification and light irradiation discharging tests. Test results revealed that although an initial surface potential by electrification in the dark had a value as same order as the case of Embodiment II, the surface potential rapidly decayed to result in a residual potential of almost null upon exposure of the device to light amount of 1 lx · sec.

A more distinguished difference between the photoconductive devices of Embodiments II and III, is a difference in surface potential decaying characteristics in the dark. Fig. 12 is a graph showing potential decaying characteristics curves designated by "d" and "c" corresponding to surface potential changes in the dark for the photoconductive devices of Embodiments II and III, respectively. As is clearly shown in Fig. 12, the surface potential decaying in the dark is sufficiently suppressed by introducing the highly doped layer 45, in addition to the residual potential lowering upon light irradiation.

Embodiment IV:

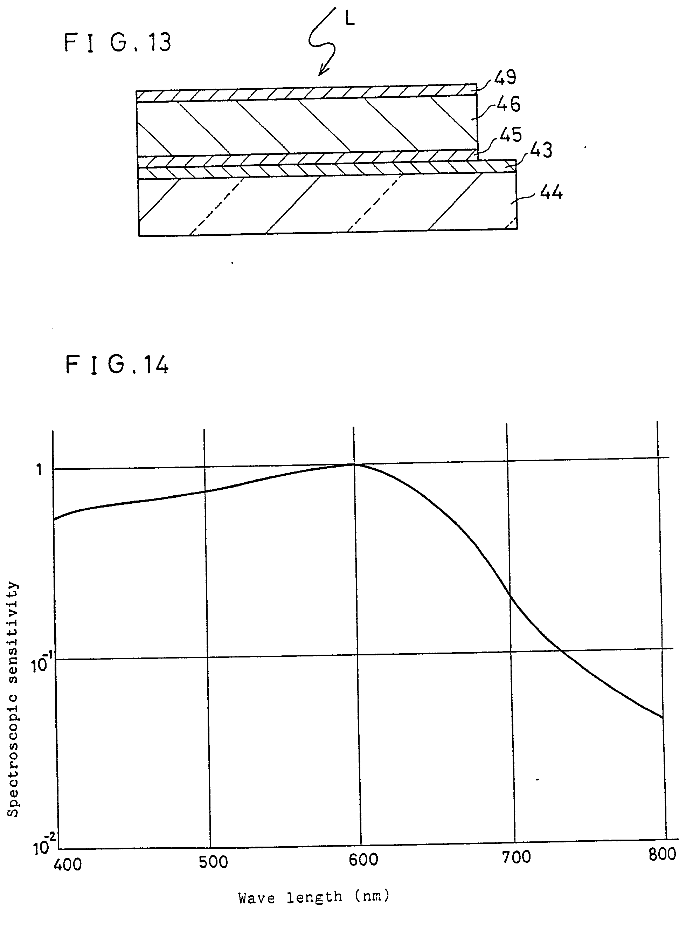

A photoconductive device was obtained with a structure similarly to the case of Embodiment III (Fig. 11). Then it was coated as shown in Fig. 13 with a silicon carbide film

$$(a \cdot Si_{1-x}C_x, \ x \approx 0.7)$$

49 of about 100 nm (1,000Å) in thickness by a glow discharging decomposition in the reaction apparatus of Fig. 1, after introducing $SiH_4$ and $C_2H_4$ gases therein. Similar corona discharging electrification on the device surface and light irradiation discharging tests were repeatedly carried out for many times in a short time, and initial electrification potential for every time was measured. It was found that the electrification potential has little dependence on electrification times.

Embodiment V:

Quartz glass substrates coated with respectively evaporated Al and indium tin oxide $(In_xSn_{1-x})_2O_3$ films was placed in the deposition apparatus of Fig. 1. The substrate was heated to 250°C, and a B-doped a · Si layer was grown by 10 nm (100 Å) in thickness by a glow discharge method, after introducing a source gas with a gas mixing ratio δ of 2%. Then, another a · Si layer doped with B and O atoms was grown by about 10 μm in thickness, after adjusting source gas flowing ratios to δ=100 ppm and $V_{N_2O}/V_{SiH_4}$=1%.

The specimen with evaporated Al coating on the substrate was similarly tested for corona electrification to induce positive charges on the specimen's surface, and light irradiation discharging tests. An initial surface potential by such electrification in the dark had a potential of about 500 V. Upon exposure of the specimen to light amount of 2 lx · sec the surface potential decreased to substantially 0 V. On the other hand, the specimen with evaporated indium tin oxide coating on the substrate was also tested for corona electrification to induce positive charges on the specimen surface, and test results revealed an electrification tendency similar to the former case of the Al evaporation film. In addition, two comparative experiments of irradiating light upon the upper surface and rear surface (through the quartz glass substrate) of the photoconductive film revealed that the case of light irradiation from the rear surface side showed higher sensitivity reflected to faster decaying of the surface potential upon light irradiation.

Embodiment VI:

A Pyrex glass (trade name) substrate coated with an evaporated indium tin oxide film was placed in the deposition apparatus of Fig. 1. The substrate was heated to 250°C, and a P-doped n-type a · Si layer was grown by 7 nm (70 Å) in thickness, after introducing a source gas with a gas mixing ratio $V_{PH_3}/V_{SiH_4}$=1%. Then, another a · Si layer doped with B and O atoms was grown by about 5 μm in thickness, after adjusting source gas flowing rates same as the case of Embodiment II. The obtained specimen was built in a 2/3-inch image pick-up tube as a target.

Fig. 14 is a graph showing a curve of spectroscopic sensitivity characteristics of the target built in the image pick-up tube. It is to be noted in the graph that sensitivity decreases for blue light (around 450—500 nm in wavelength) is not extreme and that high sensitivity characteristics with quantum efficiency nearly equal to unity are obtainable around 600 nm, where the spectroscopic sensitivity is at its maximum. The measured dark current was below 0.5 nA with a target potential of 30 V, thus resulting in a superior S/N ratio. It seems that characteristic differences in the spectroscopic curves shown in Fig. 8 and Fig. 14 arise from the existence of B atoms in the layer of photoconductive device.

Embodiment VII:

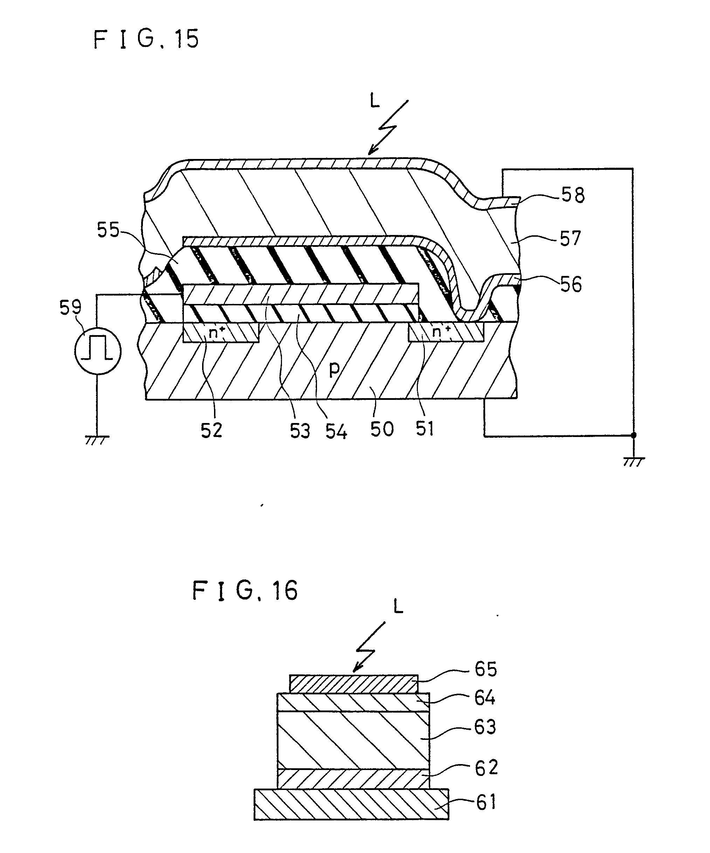

Fig. 15 is a cross-sectional view showing one device element of a solid state image sensing device provided with an a · Si layer doped with O atoms. The solid state image sensing device comprises a number of device elements and thus has a large surface area, upon which light impinges. The device element shown in Fig. 15 has a structure that an n$^+$-type region 51 is formed in a p-type semiconductor substrate 50 thereby forming a diode junction therebetween. Another n$^+$-type region 52 is also formed in the semiconductor substrate 50 in such a manner that it is electrically connected with a lead-out electrode contact electrode. The image sensing device further comprises an insulating film 54, a gate electrode 53, another insulating layer 55, a rear side electrode 56, an a · Si (H, O) film 57, and a transparent electrode film 58. Some parts of the gate electrode 53 and the insulating film 54 overlap a part of the n$^+$ type region 51. The insulating film 54 electrically isolate the gate electrode 53 from the semiconductor substrate 50. The insulating layer 55 serves to electrically isolate the rear side electrode 56 from the gate electrode 53 and the semiconductor substrate 50. The rear side electrode 56 electrically contacting the n$^+$-type region 51 serves one electrode for the diode and simultaneously a lead-out electrode for taking out photocurrent from the a · Si (H, O) film 57 as an image sensing film. The a · Si (H, O) film 57 is provided with the transparent electrode film 58 on the front surface thereof, through which light impinges on its front surface of the a · Si (H, O) film 57. The p-type substrate 50 and the transparent electrode film 58 are grounded as shown in Fig. 15.

The device operation of the solid state image sensing device will be only briefly explained in the following, since the operation is basically based on operations of conventional bucked brigade devices (BBD). When a positive pulse signal is applied to the gate electrode 53 from a pulse generator 59, an n-type inversion layer is induced at its surface of the p-type substrate 50 thereby electrically connecting the $n^+$-type region 51 with the $n^+$-type region 52. A positive voltage is initially applied to the $n^+$-type region 52, and this positive voltage is applied to the rear side electrode 56 by the formation of the surface inversion layer. Therefore, the diode formed by the $n^+$-type region 51 and the p-type substrate 50 is reversely biased.

And then, if light impinges upon the $a \cdot Si (H, O)$ film 57 through the transparent electrode film 58, electron-hole pairs are generated therein. Electrons and holes travel to the rear side electrode 56 and the transparent electrode film 58, respectively, thereby decreasing the positive potential of the rear side electrode 56. At this moment, when another positive, but lower pulse signal from the pulse generator 59 is applied to the gate electrode 53, then another n-type surface inversion layer is induced at the surface of the p-type substrate 50 thereby electrically connecting the $n^+$-type region 51 with another $n^+$-type region (not shown in Fig. 15). This connection proceeds a carrier transferring operation from the $n^+$-type region 51 to the additional $n^+$-type region where a potential well is formed. The transported charges, an amount thereof corresponding to the light amount impinged upon the $a \cdot Si (H, O)$ film 57, a subsequently transferred to an output port by a transfer pulse, and suitably signal-processed. Solid state image sensing devices comprising an $a \cdot Si (H, O)$ layer embodying the present invention have high figures of merits for the sensing device operations.

As a modified embodiment, the sensing device of Embodiment VII can comprise a multi-layer p-i-n structure, to be described later, by refering to Embodiments VIII to X. In comparison with the sensing device with single $a \cdot Si$ layer, the multi-layered structure device has an advantageous feature that transition response responding to light intensity is faster.

The $a \cdot Si (H, O)$ layer can be prepared with ease, in comparison with other conventional layers used for the image sensing devices. The $a \cdot Si (H, O)$ layer disclosed in the present application is superior in heat resistance and temperature resistance, and besides there is no need to carry out a heat treatment for it after its formation. Therefore, the solid state image sensing device provided with the $a \cdot Si (H, O)$ layer, shown in Fig. 15 can be produced during the production steps of semiconductor IC devices.

It has been described that the semiconductor device with the $a \cdot Si (H, O)$ film has a dark resistance much higher than that of the conventional device. High resistance values are obtainable for the gas flowing rate of $V_{N_2O}/V_{SiH_4}$ from about $1 \times 10^{-4}$ to $10^1$, for the case of the gas

flowing rate $\delta$ nearly equal to 100 ppm. This means that it is possible to change oxygen atom concentration continuously from a state that a slight amount of oxygen atoms are mixed as an impurity to another state that an $a \cdot Si$ layer turns to an amorphous silicon dioxide layer. By increasing the oxygen atom addition, the dark resistance increases. On the other hand, it is found that preferably flowing ratios $V_{N_2O}/V_{SiH_4}$ are between $10^{-3}$ and $10^0$, in view of photoconductive characteristics necessary for the obtained $a \cdot Si (H, O)$ films. When the flowing ratio $\delta(V_{B_2H_6}/V_{SiH_4})$ is changed while keeping the flowing ratio $V_{N_2O}/V_{SiH_4}$ constant at around $5 \times 10^{-2}$, the dark resistance increases as the gas flowing ratio $\delta$ increases in the range from null to upto around $10^{-4}$, and the dark resistance is almost constant in the range from $\delta = 10^{-4}$ to $10^{-2}$. On the other hand, the photoconductivity is almost constant within measurement errors, irrespective of the gas flowing ratio $\delta$ (between $\delta = 0$ and $\delta = 10^{-2}$). These characteristics are similarly observed for the case of employing $Ga(CH_3)_3$ gas for a p-type dopant, instead of $B_2H_6$ gas.

For Embodiments I—VII described above, $O_2$ or $N_2O$ gas is employed for the introduction of O atoms into the $a \cdot Si (H, O)$ layers. It is naturally possible to employ other gases for the introduction of O atoms, for example $CO_2$ gas, which gases contain O atoms and enable $SiH_4$ gas react with O atoms therein in a plasma gas.

It will be described in the following descriptions in connection with Embodiments VIII to X that p-type $a \cdot Si$ layers doped with O atoms are used for solid state devices with multi-layered p-i-n structures.

Embodiment VIII:

A photoconductive device with a p-type $a \cdot Si$ layer for a p-i-n structure shown in Fig. 16. The photoconductive device comprises a conductive substrate 61 made of a stainless plate, an n-type $a \cdot Si (H)$ film 62, an i-type $a \cdot Si (H)$ film 63, a p-type $a \cdot Si (H, O)$ film 64, and a semi-transparent Au film 65. The n-type $a \cdot Si (H)$ film 62 is formed on the conductive substrate 61 by about 30 nm (300 Å) in thickness, by mixing $PH_3$ gas with $SiH_4$ gas. The i-type $a \cdot Si (H)$ film 63 is formed by about 500 nm (5,000 Å) by decomposing only $SiH_4$ gas. The p-type $a \cdot Si (H, O)$ film 64 is formed by about 7 nm (70 Å) in thickness, by employing the gas mixing ratios $\gamma$ of 3% and $\delta$ of 1%. The semi-transparent Au film 65 evaporated on the p-type $a \cdot Si (H, O)$ film 64 serves as a lead-out electrode layer, and can be replaced by other material layers such as Pt, Cr, or Pd layer.

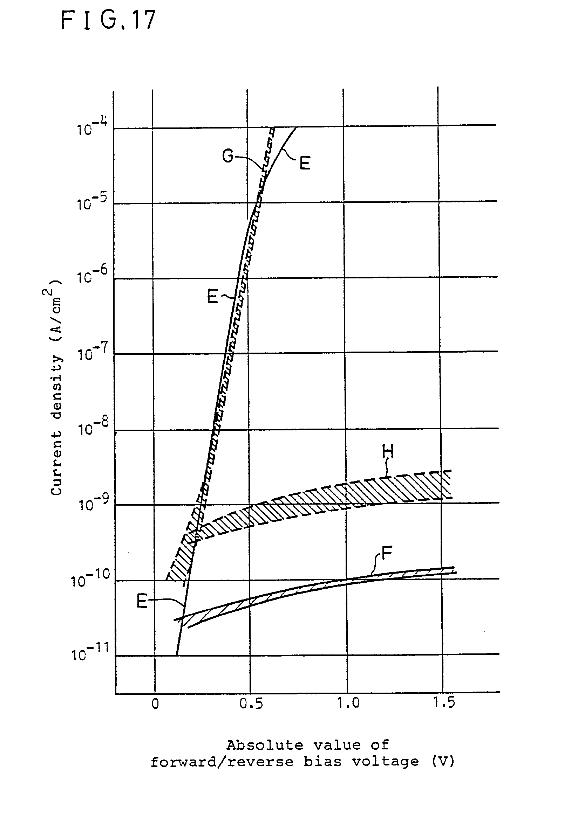

Fig. 17 is a graph showing current-voltage characteristic curves in the dark for making a comparison between the photoconductive devices of the structure in Fig. 16 and provided with the p-type $a \cdot Si (H, O)$ and with a p-type $a \cdot Si (H)$ without oxygen doping. Curves designated by "E" and "F" correspond to the characteristic curves of applying a forward bias and a reverse bias, respectively, to the photoconductive device with the p-type a · Si (H, O) film. On the other hand, curves designated by "G" and "H" correspond to the characteristic curves of applying a forward bias and a reverse bias, respectively, to the photoconductive device with the p-type a · Si (H, B) layer.

When the photoconductive device with the p-type a · Si (H, O) layer embodying the present invention is reversely biased, the obtainable dark current thereof is less than that of the conventional photoconductive device with the p-type a · Si (H) layer, by the order of about unity. On the other hand, upon light irradiation the photoconductive current of the device with the p-type a · Si (H, O) layer embodying the present invention is in the order as same as that of the conventional photoconductive device with the p-type a · Si (H) layer. These test results indicate that it is possible to improve the S/N ratio by employing the a · Si (H, O) film for the photoconductive device.

In general, diode devices are qualitatively evaluated by the quality factor "n" given by the following formula:

$$I = I_0 \exp(qV/nRT),$$

where I is a current flowing through the device, $I_0$ a saturation current, q an electric charge, V a bias voltage, R Boltzmann's constant, and T an absolute temperature at the measurement, respectively. The ideal value of the quality factor "n" is unity, and it is known that the smaller value the diode has, the better a charge transport efficiency in the device is.

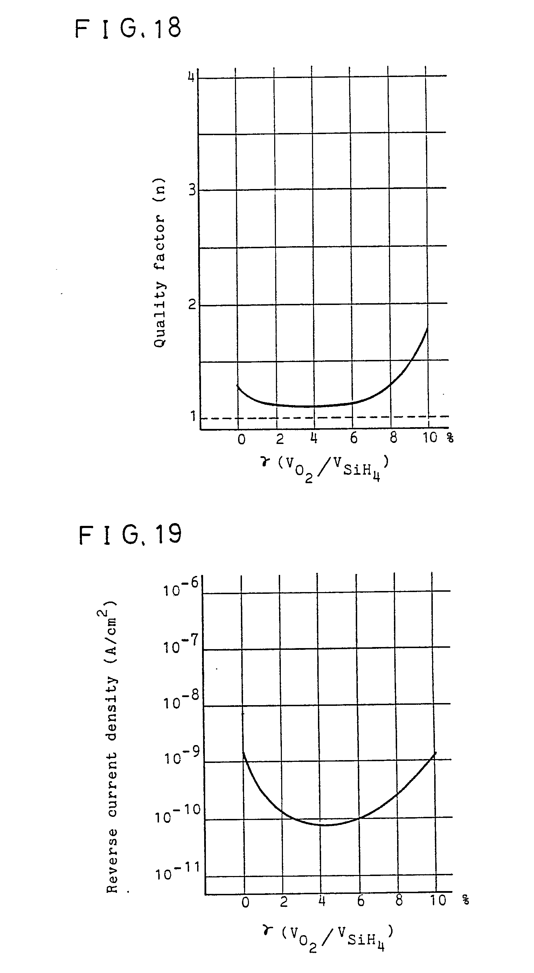

Fig. 18 is a graph showing a relationship between quality factor "n" of a photoconductive device embodying the present invention, with the p-i-n structure and applied a forward bias voltage, and gas flowing rate γ at the forming of the p-type a · Si (H, O) film. From the measurement results shown in Fig. 18, it is observed that the photoconductive devices embodying the present invention having smaller quality factor values are more superior than the conventional device with the a · Si (H) film, for γ smaller than about 8%, and that for γ larger than about 8% the quality factor becomes larger thus worsening the charge transport efficiency. This means that the p-type a · Si (H, O) film for the photoconductive device embodying the present invention is preferable to be formed under the condition of γ lower than 8%.

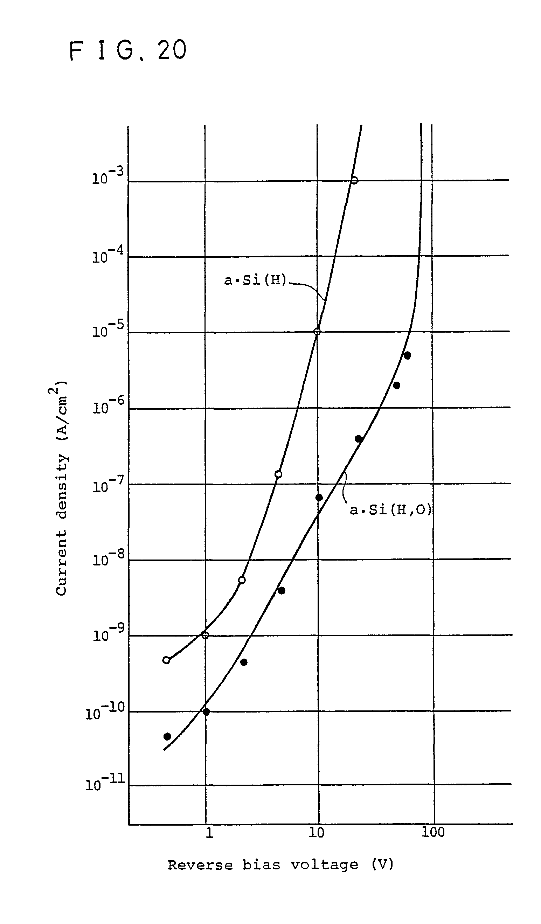

Fig. 19 is a graph showing a relationship between a reverse current density of a photoconductive device with a p-i-n structure embodying the present invention in the dark with a reverse bias voltage of 1.0 V and the gas flowing ratio γ at the forming of its p-type a · Si (H, O) film. Although it is very difficult to detect a preferable lower limit of the $O_2$ mixing ratio by the present analyzing technology, it is seen in Fig. 19 that the reverse current density decreases for the gas flowing ratio γ of a range from about 1% to about 8%. This ratio range corresponds to the condition that the ratio of $O_2$ atoms to Si atoms in the p-type a · Si (H, O) film is 0.02 to 0.16, by referring to the relationship shown in Fig. 3.

Fig. 20 is a graph showing reverse current voltage characteristic curves obtained in the dark for photoconductive devices with a p-type a · Si (H, O) film and a p-type a · Si (H) film. The reverse bias voltage range shown in Fig. 20 is much wider than the case of Fig. 17.

It is seen in Fig. 20 that the photoconductive device with the p-type a · Si (H, O) film has a smaller reverse current and besides a higher reverse breakdown voltage. This means that operable voltage ranges can be set wider by employing the photoconductive device with the p-type a · Si (H, O) film embodying the present invention than the case of the conventional photoconductive device.

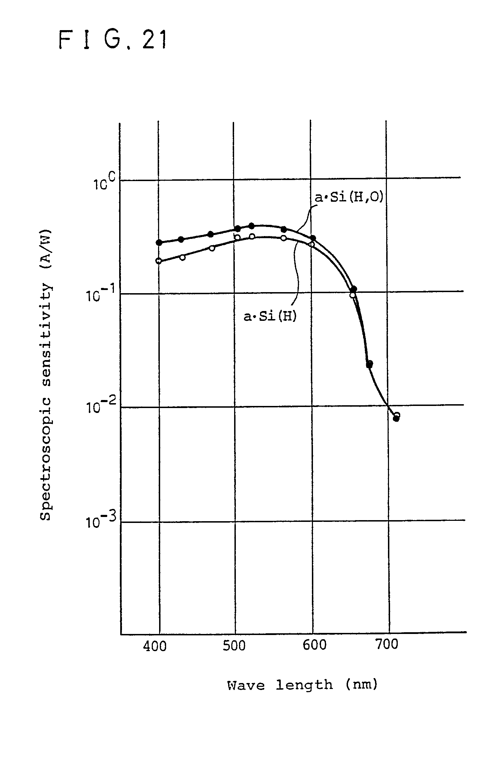

Fig. 21 is a graph showing spectroscopic characteristics of a photoconductive device embodying the present invention and a conventional photoconductive device, which devices are respectively applied by bias voltages of 0.5 V and 3 V, in order to make their reverse current values in the dark almost equal to each other. It is seen from Fig. 21 that the photoconductive device with the p-type a · Si (H, O) film has a spectroscopic sensitivity higher than the conventional photoconductive device with the p-type a · Si (H) film. In particular, the photoconductive device embodying the present invention has an ideal spectroscopic characteristic in the wave length range around 400—500 nm, where the quantum efficiency approaches to unity.

By employing the p-i-n structure with the p-type a · Si (H, O) layer for the photoelectric device, it is possible to obtain superior device characteristics that its dark current is small, that the sensitivity is high in the visible light wave length range, and that the operable bias voltage range is wide. Therefore, such high sensitive photoelectric device is suitable for a solid state image sensing device provided with a photosensitive layer, for a line sensor used for a facsimile apparatus, a photo coupler, etc.

Embodiment IX:

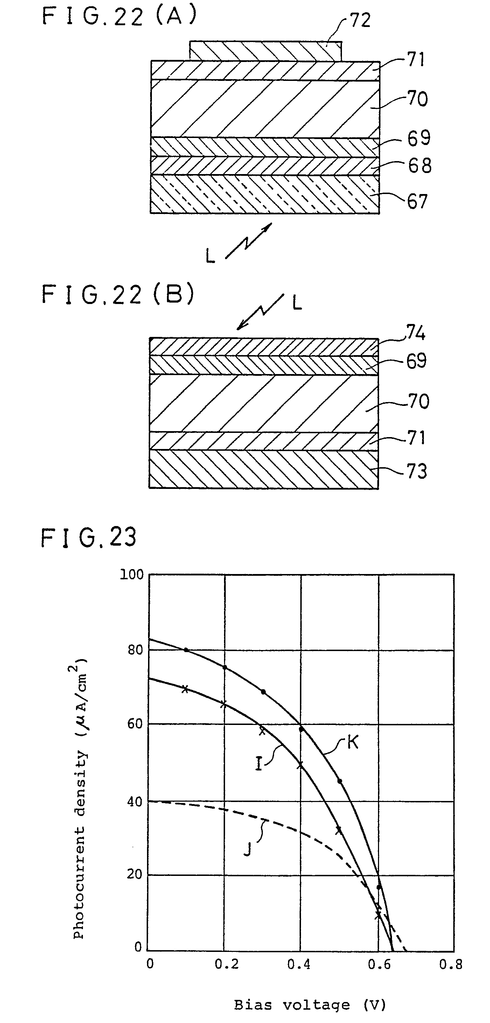

Fig. 22(A) shows a structure of a photovoltaic device comprising a p-type a · Si (H, O) film embodying the present invention. The photovoltaic device is obtained by the following steps. A $p^+$-type a · Si (H, O) film 69 is deposited on a transparent conductive film 68 coating a glass substrate 67, under gas flowing ratio conditions of γ=0.05 and δ=0.02. Then, a non-doped a · Si (H) layer 70 as an i-type layer is deposited by about 500 nm (5,000 Å), followed by the deposition of an $n^+$-type a · Si (H) layer 71 by 30 nm (300 Å). Subsequently, a gold layer 72 is evaporated on the $n^+$-type a · Si (H) layer 71.

The photovoltaic device embodying the present invention has a photovoltaic characteristic, as shown by a curve designated as "I" in Fig. 23, under 500 lx illumination from a fluorescent lamp. The photovoltaic device has the following figures of merits. Open circuit voltage (Voc) is 635 mV, short circuit current density (Jsc) 72 µA/cm', and fill factor (FF) is 0.43, respectively. On the other hand, a conventional device comprising a p-type $a \cdot Si$ (H) layer (prepared under gas mixing ratio conditions of $\gamma=0$ and $\delta=0.002$, and film thickness of 10 nm (100 Å) instead of the $p^+$-type $a \cdot Si$ (H, O) layer 69, shows a photovoltaic characteristic as shown by a curve designated as "J" in Fig. 23. By comparing these curves I and J, it is to be noted that a considerable improvement in the output characteristic can be realized by employing the p-type $a \cdot Si$ (H, O) layer.

Embodiment X:

Fig. 22(B) shows a photovoltaic device comprising on a stainless plate 73 an $n^+$-type layer 71, an i-type layer 70 and a $p^+$-type $a \cdot Si$ (H, O) layer 69, deposited in the reverse order to the case of Embodiment IX. A transparent conductive film 74 is evaporated on the $p^+$-type layer 69. The output characteristics of the photovoltaic device of this embodiment are shown by a curve designated as "K", that is Voc=640 mV, Jsc=83 µA/cm" and FF=0.47. These figures of merits are satisfactory for the device operation of the photovoltaic device.

As has been described above with reference to Embodiments IX and X, it is possible to improve the figures of merits of the photovoltaic device, by employing the $a \cdot Si$ (H, O) layer therefor, particularly for a p-type layer. Further, it is still more possible to improve the figures of merits of the photovoltaic device with the structure shown in Fig. 22(B), by employing an $n^+$-type layer with a suitably increased band gap thereof (this is possible by suitably controlling the gas mixing ratios for obtaining a preferable impurity concentration for the layer).

In conclusion, the present invention can provide semiconductor devices with small dark current, high reverse breakdown voltage, and superior forward I—V characteristics, by employing $a \cdot Si$ (H, O) layers disclosed in the present application. These semiconductor devices are suitable for photoelectric devices used for the solid state image sensing devices, facsimile equipment, for photovoltaic devices such as solar cells.

**Claims**

1. A semiconductor photoelectric device comprising a photosensitive amorphous silicon layer containing oxygen, in which the ratio of oxygen atoms to silicon atoms is 0.02—0.16 and which has the function to transfer charges photoelectrically produced in said amorphous silicon layer, to a semiconductor substrate.

2. A semiconductor picture pick-up device in accordance with claim 1, wherein said semiconductor substrate comprises a bucket brigade device formed therein.

3. A semiconductor photoelectric device in accordance with claim 1 or 2, wherein said amorphous silicon layer has a p-i-n structure.

**Patentansprüche**

1. Photoelektrische Halbleitervorrichtung, umfassend eine lichtempfindliche amorphe, Sauerstoff enthaltende Siliziumschicht, in welcher das Verhältnis von Sauerstoffatomen zu Siliziumatomen 0,02—0,16 beträgt und welche die Funktion hat, Ladungen, die in der genannten amorphen Siliziumschicht erzeugt sind, auf ein Halbleitersubstrat zu übertragen.

2. Bildaufnahme-Halbleitervorrichtung nach Anspruch 1, in welcher das Halbleitersubstrat eine in ihr gebildete Eimerketten-Schaltung umfaßt.

3. Photoelektrische Halbleitervorrichtung nach Anspruch 1 oder 2, in welcher die amorphe Siliziumschicht eine p-i-n Struktur hat.

**Revendications**

1. Dispositif photoélectrique à semi-conducteur comprenant une couche de silicium amorphe photosensible contenant de l'oxygène, dans lequel le rapport entre atomes d'oxygène et atomes de silicium est 0,02—0,16 et qui a la fonction de transférer des charges produites photoélectriquement dans la couche de silicium amorphe à un substrat à semi-conducteur.

2. Dispositif de prise d'images à semi-conducteur selon la revendication 1, dans lequel le substrat à semi-conducteur comprend un dispositif à semi-conducteur à transfert de charges formé dedans.

3. Dispositif photoélectrique à semi-conducteur selon la revendication 1 ou la revendication 2, dans lequel la couche de silicium amorphe a une structure p-i-n.

F I G, 1

F I G. 2

0 035 146

Optical band gap (eV) vs Volume ratio $\gamma\ (V_{O_2}/V_{SiH_4})$

⊙ a·Si(H,O)

△ a·Si(H)

$(\gamma = 0)$

F I G. 3

X-ray intensity ratio vs Source gas volume composition ratio $\gamma\ (V_{O_2}/V_{SiH_4})$

2

F I G.4

F I G.5

3

FIG.6

FIG.8

○ a·Si(H,O)

● a·Si(H)

Spectroscopic sensitivity (A/W)

Wave length (nm)

F I G . 7

# F I G. 9

FIG.10

FIG.11

FIG.12

Surface potential in the dark

Time (second)

FIG.13

FIG.14

Wave length (nm)

F I G. 15

F I G. 16

# FIG.17

Absolute value of
forward/reverse bias voltage (V)

F I G. 18

F I G. 19

F I G、20

F I G. 21

Wave length (nm)

FIG.22(A)

FIG.22(B)

FIG.23

Bias voltage (V)